# EUROPEAN PATENT SPECIFICATION

(11) **EP 2 455 332 B1**
(45) Date of publication and mention of the grant of the patent: **12.02.2014**
(21) Application number: 10191819.1
(22) Date of filing: 19.11.2010
(51) Int. Cl.: B81C 1/00

(54) **Method for producing temporary cap on a MEMS device**
Verfahren zur Herstellung einer temporären Kappe auf einem MEMS-Bauteil
Procédé pour la production d'un capot temporaire pour un dispositif MEMS

(43) Date of publication of application: 23.05.2012
(73) Proprietor: IMEC, 3001 Leuven (BE)
(72) Inventor: Phommahaxay, Alain, B-3000, LEUVEN (BE); Bogaerts, Lieve, B-3460, BEKKEVOORT (BE); Soussan, Philippe, FR-13009, MARSEILLE (FR)
(74) Representative: Pronovem

(56) References cited:
- US-A1- 2002 076 873
- US-A1- 2005 275 079
- US-A1- 2007 105 370
- CHAO-CHANG HU ET AL: "Solder bonding with a buffer layer for MOEMS packaging using induction heating", MICROSYSTEM TECHNOLOGIES ; MICRO AND NANOSYSTEMS INFORMATION STORAGE AND PROCESSING SYSTEMS, SPRINGER, BERLIN, DE, vol. 12, no. 10-11, 6 April 2006 (2006-04-06), pages 1011-1014, XP019429630, ISSN: 1432-1858, DOI: DOI:10.1007/S00542-006-0103-5
- WITVROUW A ET AL: "Packaging of 11 MPixel CMOS-Integrated SiGe Micro-Mirror Arrays", MICRO ELECTRO MECHANICAL SYSTEMS, 2009. MEMS 2009. IEEE 22ND INTERNATIONAL CONFERENCE ON, IEEE, PISCATAWAY, NJ, USA, 25 January 2009 (2009-01-25), pages 136-139, XP031444248, ISBN: 978-1-4244-2977-6
- ATSUSHI HASEGAWA ET AL: "Heat -Resistant, Self-Releasing Tape And Its Application", POLYMERS AND ADHESIVES IN MICROELECTRONICS AND PHOTONICS, 2007. POLYTR ONIC 2007. 6TH INTERNATIONAL CONFERENCE ON, IEEE, PI, 1 January 2007 (2007-01-01), pages 290-292, XP031139385, ISBN: 978-1-4244-1130-6

## Description

### Field of the Invention

The present invention is related to the production of semiconductor devices, and primarily to the production of MEMS devices (Micro Electromechanical Systems). The invention is particularly related to the production of a capping structure on such devices with the purpose of protecting the MEMS devices.

### State of the art

MEMS devices are quite sensitive and can not be diced after release of the mechanical structures unless they are protected on the wafer level. Also, even if release is done after dicing, it is still difficult to handle the released dies. Damaged structures are often noticed during handling (example during shipping to a third party or during wire bonding) of the device. Most commercial MEMS are packaged by a permanent capping chip or capping layer at the wafer level before dicing. This is however not always possible, for example in the case of optical MEMS (Micro Opto-Electromechanical Systems or MOEMS). For MOEMS it is necessary that the light can interact with the MEMS, and as a permanent cap is never perfectly transparent, such a cap can hinder that interaction. In those cases it is therefore necessary to find a temporary solution to protect the structures.

One known development of this type is the use of "UV dicing" tape to protect the devices, see document US6555417. However, this technique leaves some residues after tape removal. Certainly if the tape is also situated above the devices, this might damage the devices. The tape can be patterned to be only present in the ring area around the devices, but then non-standard tools (for semiconductor processing) such as a programmable fully- automatic cutting table need to be used.

A related technique is presented in WITVROUW A ET AL: "Packaging of 11 MPixel CMOS-Integrated SiGe Micro-Mirror Arrays", MEMS 2009, IEEE, PISCATAWAY, NJ, USA, 25 January 2009, pages 136-139. A glass cap is bonded to a semiconductor die by a ring-patterned UV-sensitive adhesive tape. After dicing and cleaning the glass cap is removed by irradiating the adhesive tape.

### Summary of the invention

The invention is related to methods and devices as described in the appended claims.

The invention is thus related to a method for producing a temporary cap on a semiconductor device, in particular a MEMS device, said method comprising the steps of :
- Providing a semiconductor substrate,
- Producing on a surface of said substrate one or more semiconductor devices,
- Producing a release layer at least in an area of said substrate surface encircling one or more of said devices or in one or more portions of said area,
- Producing on said (portions of said) area and in contact with said release layer : one or more wall structures around said one or more devices,
- Producing on said wall structure (s) a cap so as to protect said one or more devices.

Said release layer may be produced during said step of producing the semiconductor device(s) on said surface. Alternatively, said release layer may be produced in addition to said step of producing the semiconductor device(s) on said surface.

In the above, the term 'release layer' is to be understood as follows : the thickness and materials of the release layer, the wall structure(s) and the substrate are chosen in such a way that when a force is applied to the wall structure and/or the cap, said force being sufficient for removing the cap from the substrate, breaking will occur in the release layer, along the interface between the release layer and the wall structure, or along the interface between the release layer and the substrate.

According to a preferred embodiment :
- said semiconductor substrate is a silicon substrate,
- said release layer is obtained by depositing a sequence of Silicon Carbide layers by Plasma Enhanced Chemical Vapour Deposition (PECVD).

Preferably, said release layer has a different thermal expansion coefficient than the portion of the wall structure which is in direct contact with said release layer.

According to an embodiment, said wall structure is produced by :
- Depositing a metal layer or a stack of metal layers on said release layer, to thereby form a first wall substructure around said one or more devices,
- Providing a cap and depositing a metal layer or a stack of metal layers on said cap, to thereby form a second wall substructure, corresponding to said first wall substructure,
- Contacting said first and second wall substructures while adding heat so as to form a welded connection between said first and second wall substructures, to thereby form said wall structure.

Said first wall substructure may comprise a Cu layer, and said second wall substructure may comprise a Sn layer, wherein said welded connection is a Cu-Sn bond.

The invention is further related to a capped semiconductor device, in particular a capped MEMS device, comprising :
- A substrate comprising on its surface one or more semiconductor devices, and a release layer at least in an area of said substrate surface encircling one or more of said devices or in one or more portions of said area,
- On said (portions of said) area and in contact with said release layer : a wall structure,
- a cap on top of said wall structure.

In a capped semiconductor device according to the invention, said substrate is a silicon substrate, and said release layer consists of a stack of SiC layers.

Said wall structure may comprise at least two regions of different metals connected by welding.

Preferably, said release layer has a different thermal expansion coefficient than the portion of the wall structure which is in direct contact with said release layer.

The invention is also related to a method for removing a temporary cap from a capped device according to the invention, said method comprising:
- Heating said release layer and at least a portion of said wall structure which is in contact with said release layer,
   OR
- Heating said release layer and at least a portion of said wall structure which is in contact with said release layer, whilst simultaneously applying a mechanical force to said wall structure and/or said cap,
   OR
- applying a mechanical force to said wall structure and/or said cap.

The invention is advantageous because the release layer may be produced by standard production techniques. The removal of the cap is easily obtained by peeling of the release layer and does not require complex procedures such as UV or heat release.

### Brief description of the figures

Figures 1a and 1b illustrate the general principle of the present invention.

Figures 2a to 2f illustrate various steps in the method according to one embodiment of the invention.

Figure 3 shows an example of the composition of wall structures used in the method of the invention.

The appended figures are illustrative only and the relative dimensions of the featured components may differ substantially from the figures.

### Detailed description of the invention

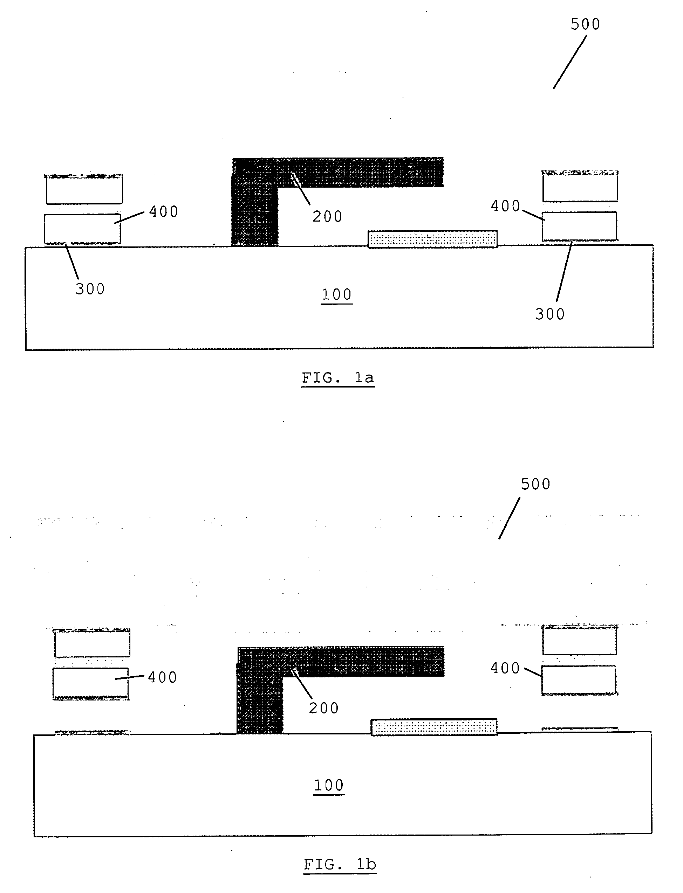

Figures 1a and 1b illustrate the general principle of the method of the invention. A wafer 100 is shown comprising at least one MEMS device 200 on its surface, produced by a known MEMS fabrication method. According to the invention, a release layer 300 (as defined above) is produced on the wafer, at least in an area encircling one or more MEMS, and a support wall structure 400 is produced on and in contact with said release layer. After that, a cap 500 is produced on said support wall structure. The composition and mechanical characteristics of the release layer 300 and of the wall structure 400 are such that the cap and the support wall structure are removable from the wafer by exercising a removing force on the wall structure and/or the cap, wherein the release layer 300 or the interface between the wall structure 400 and the release layer 300 or the interface between the substrate 100 and the release layer breaks more easily than the support wall(s) of the wall structure 400 to thereby release the cap 500 and cap support wall structure 400 from the MEMS wafer 100, as illustrated in figure 1b.

The invention is further related to a method for removing the temporary cap, which involves exerting a removing force on the cap 500 and/or the wall structure 400. Preferably, the release layer 300 has a different thermal expansion coefficient than the wall structure 400, or at least than the portion of said wall structure which is in direct contact with the release layer. In that case, a removing force is generated by heating the release layer and at least the portion of the wall structure 4 in contact with the release layer, to thereby create a differential thermal expansion between the release layer and said wall structure, leading to a heat induced stress which generates a removing force oriented substantially along the plane of the release layer 300. Possibly, a mechanical removing force may be applied in stead of or may be combined with said heat-generated removing force.

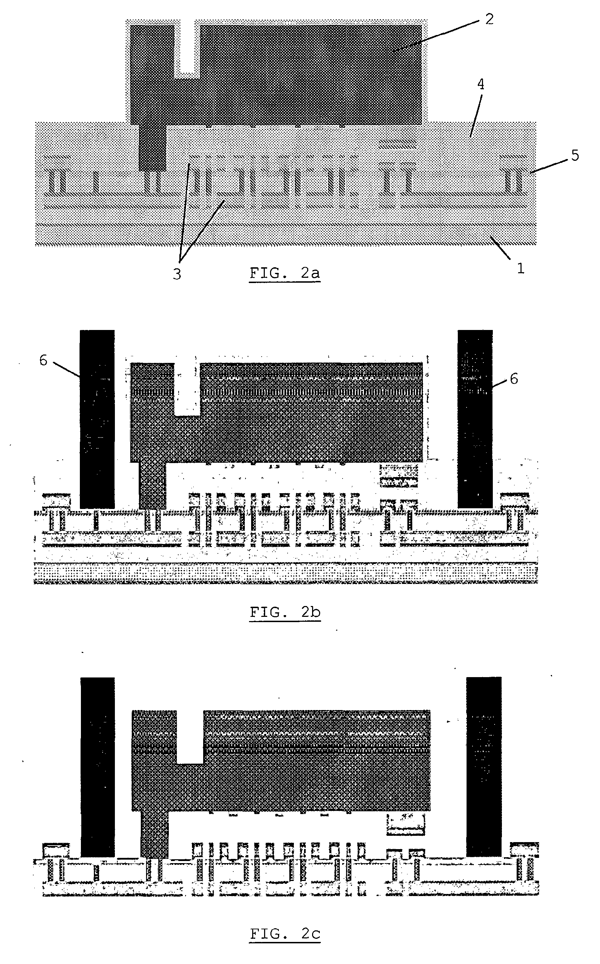

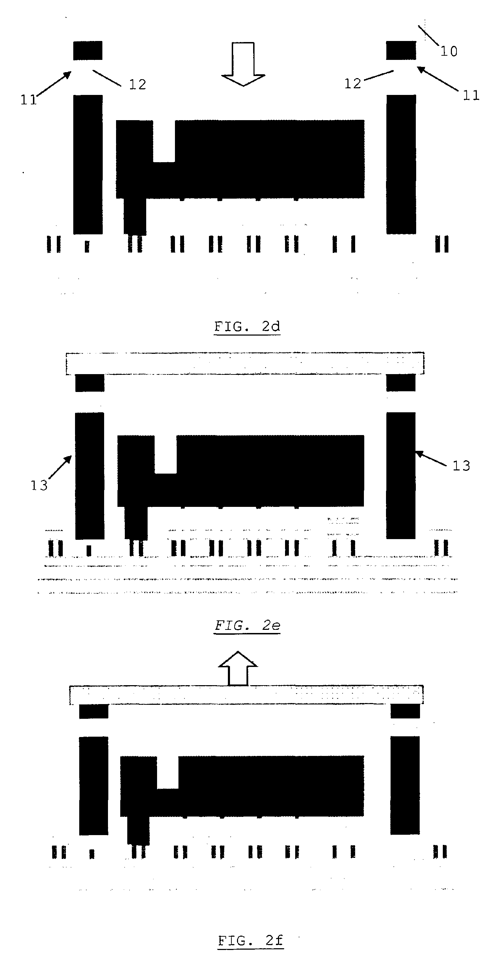

The release layer can be applied during the MEMS production process. It can be a functional layer of said process, which simultaneously acts as the release layer of the invention. Alternatively, the release layer may be produced in addition to (preferably after) the MEMS production process. The first case, wherein the release layer is also a functional layer in the MEMS production process, is illustrated in the embodiment of figures 2a to 2f.

Figure 2a shows a MEMS device 2, produced on a Si wafer 1. Metallic connection structures 3 are visible, as well as a sacrificial silicon oxide layer 4 and a silicon carbide passivation layer 5, typically applied during MEMS processing to protect the underlying layers. The passivation layer 5 also acts as the release layer of the invention. In the method of the invention, this passivation layer may be produced as a sequence of thin SiC layers, through a series of Plasma Enhanced Chemical Vapour Deposition (PECVD) steps. For example, a sequence of 4 layers of SiC each having a thickness of 80nm may be produced.

By known litho/etch steps in combination with various known deposition techniques such as Physical Vapour Deposition (PVD) and Electrochemical Deposition (ECD), a wall structure 6 is produced on the passivation layer 5, for example a structure mainly consisting of Cu (Figure 2b), and encircling the MEMS device. The wall 6 is preferably formed by a sequence of layers, e.g. a diffusion barrier layer followed by a thin PVD Cu layer and a thicker ECD Cu layer (see example further in text). The height of the wall is higher than the height of the MEMS device 2. In the example shown, a trench is etched in the sacrificial oxide layer 4 to expose the release layer 5 in an area encircling the MEMS device 2. After that, by a combination of PVD and ECD steps, the wall structure 6 consisting mainly of Cu is produced on the exposed portion of the release layer 5. Preferably, the release layer has a thermal expansion coefficient which is different from the thermal expansion coefficient of the wall structure 6, or at least different from the thermal expansion coefficient of the portion of the wall structure that is in direct contact with the release layer.

Then the sacrificial oxide layer 4 is removed, for example by a vapour HF etch (Figure 2c). After that, a cap 10 is provided. The cap can be a piece of any suitable material and shape, for example a discshaped piece of silicon, glass, metal. In the embodiment shown, the cap comprises on its surface a second wall structure 11, corresponding in circumference and wall thickness to the first wall structure 6 on the MEMS wafer 1. As seen in figure 4, the cap is lowered onto the MEMS wafer, and the corresponding wall structures are welded together by addition of heat (Figure 2e). This may be done by heating the gripping tool used to manipulate and place the cap wafer 10 onto the MEMS wafer. Preferably, only the gripping tool is heated and not the MEMS wafer, in order to avoid heating the release layer at this stage.

The wall structure 11 on the cap wafer may comprise a layer 12 of Sn at the top, so that the weld is obtained by formation of a Sn-Cu bond, as known in the art. In stead of a separate cap 10 applied on each MEMS device 2, a larger cap wafer may be applied comprising a plurality of wall structures 11, corresponding to a plurality of wall structures 6 around MEMS devices on the MEMS wafer 1. After welding of the cap wafer to the plurality of wall structures 6 on the MEMS wafer, separate capped MEMS devices are then obtained by dicing the welded MEMS and cap wafers.

A capped MEMS device is thus obtained as shown in figure 2e, wherein the MEMS device 2 is protected by a wall structure 13 (the combined walls 6 and 11) around the MEMS 2 and a cap 10 on top of the wall 13.

The resulting capped MEMS device of figure 2e may be transported and handled while the MEMS remains in a controlled environment. When the MEMS device is mounted in its final place, the cap may be removed by applying a removing force to the cap 10 and/or the wall structure 13 (Figure 2f). Preferably, this is done by heating the release layer 5 and at least the portion of the wall 13 in contact with the release layer. Due to the difference in expansion coefficient between the release layer 5 and the walls, a transverse force is exerted on the release layer. Heating of the release layer may be done by heating the substrate and/or the cap. Depending on the materials used, this heat-induced transverse force may be sufficient to cause breaking of the release layer. Otherwise, heating may be combined with a mechanical force. For example, when the wall 13 is a circular wall, the cap may be gripped and twisted around the wall's central axis perpendicular to the substrate. Still alternatively, such a twisting force may be applied without heating. When the release layer is sufficiently weak mechanically, such a mechanical force will cause breaking along a plane in the release layer or along the interface between the release layer and the walls 13, or along the interface between the release layer and the substrate.

In the case of a release layer consisting of SiC sublayers, failure occurs along one or more interfaces between said sublayers. According to the preferred embodiment, the geometrical dimensions (height, width, shape) of the wall structure 13 must be properly designed so that the stress is highest in the release layer 5. In this way, peeling off of the release layer is ensured in stead of breaking of the wall structure.

The invention is not limited to the embodiment shown in figures 2a to 2f. Again with reference to figures 1a and 1b, the wall 400 is preferably a continuous wall structure encircling the MEMS device, for example a wall with a circular cross section so that a cylindrical enclosure is formed around the MEMS. However, the wall can also be formed of wall portions placed around the MEMS with open spaces in between the wall portions. As stated, the release layer 300 can be a layer applied during the MEMS production process, but it can also be a layer applied after said process. In the latter case, the release layer can be produced at least in a zone encircling the MEMS device(s) to be protected, or in portions of said zone, whereafter the walls 400 are produced on the release layer present in said zone or in said zone portions. The walls 13 are not limited to the version obtained by a welding of two wall portions, one on the substrate and one on the cap or cap wafer. According to other embodiments, the cap may be attached directly to a wall structure 6 deposited on the release layer.

The invention is also related to a semiconductor device, in particular a MEMS device provided with a temporary cap obtainable by the method of the invention, such as the device shown in Figure 2e.

### Examples

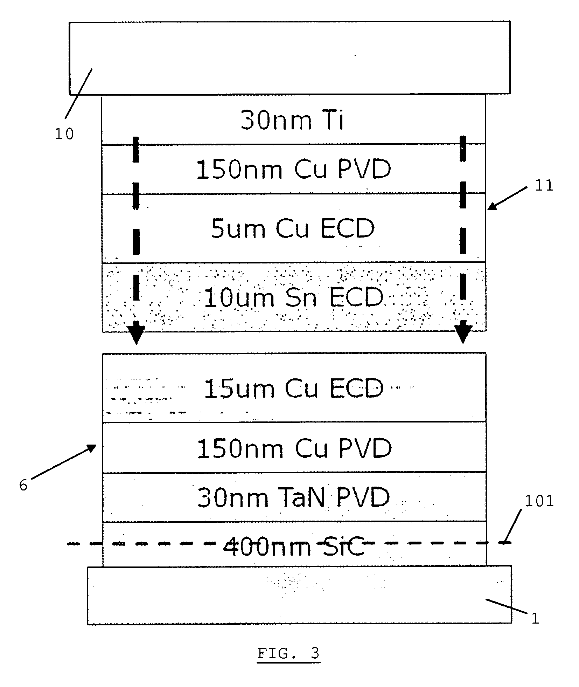

Figure 3 shows an example of the detailed composition of the wall structures 6 and 11. Wall structure 6 consists of the following layers produced onto a 400nm SiC layer, which is the release layer of the invention, itself consisting of 4 SiC layers of 100nm thick deposited at 350°C with interface hardening by He plasma in between each layer deposition:
- a 30nm TaN diffusion barrier, applied by PVD
- a 150nm Cu layer applied by PVD
- a 15µm Cu layer applied by ECD
The cap wafer comprises wall structure 11, consisting of :
- a 30nm Ti layer
- a 150nm Cu layer applied by PVD,
- a 5µm Cu layer applied by ECD
- a 10µm Sn layer applied by ECD
In the welding step, the 15µm Cu layer and 10µm Sn layer are contacted and welded together by heating only the cap at 250°C and by applying a mechanical pressure of 0.1 MPa.

The line 101 illustrates the failure interface when the cap is removed : failure takes place along one or more of the interface planes between the SiC sublayers that define the release layer 5. The height of the resulting wall structure 13 is preferably higher than 20µm. The width of the wall structure is preferably about 100µm. Release can be obtained by heating the full assembly to 250°C and by pulling the cap upwards with a gripping tool.

## Claims

1. A method for producing a temporary cap on a semiconductor device, in particular a MEMS device, said method comprising the steps of :
• Providing a semiconductor substrate (1,100),
• Producing on a surface of said substrate one or more semiconductor devices (2,200),
• Producing a release layer (5,300) in an area of said substrate surface, the area comprising at least a region encircling one or more of said devices or one or more portions of said region,
• Producing on said area and in contact with said release layer : one or more wall structures (13,400) around said one or more devices,
• Producing on said one or more wall structures a cap (10,500) so as to protect said one or more devices,
wherein the thickness and materials of the release layer, the one or more wall structures and the substrate are chosen in such a way that when a force is applied to the wall structure and/or the cap, said force being sufficient for removing the cap from the substrate, breaking will occur in the release layer, along the interface between the release layer and the one or more wall structures, or along the interface between the release layer and the substrate.

2. Method according to claim 1, wherein said release layer (5,300) is produced during said step of producing the one or more semiconductor devices on said surface.

3. Method according to claim 1, wherein said release layer (5,300) is produced in addition to said step of producing the one or more semiconductor devices on said surface.

4. Method according to any one of claims 1 to 3, wherein :
• said semiconductor substrate (1,100) is a silicon substrate,
• wherein said release layer (5,300) is obtained by depositing a sequence of Silicon Carbide layers by Plasma Enhanced Chemical Vapour Deposition.

5. Method according to any one of claims 1 to 4, wherein said release layer (5,300) has a different thermal expansion coefficient than the portion of the wall structure (13,400) which is in direct contact with said release layer.

6. Method according to any one of claims 1 to 5, wherein said wall structure (13) is produced by :
• Depositing a metal layer or a stack of metal layers on said release layer (5), to thereby form a first wall substructure (6) around said one or more devices (2),
• Providing a cap (10) and depositing a metal layer or a stack of metal layers on said cap, to thereby form a second wall substructure (11), corresponding to said first wall substructure (6),
• Contacting said first and second wall substructures while adding heat so as to form a welded connection between said first and second wall substructures, to thereby form said wall structure (13).

7. Method according to claim 6, wherein said first wall substructure (6) comprises a Cu layer, and said second wall substructure (11) comprises a Sn layer, and wherein said welded connection is a Cu-Sn bond.

8. A capped semiconductor device, comprising:
• A substrate (1,100) comprising on its surface one or more semiconductor devices (2,200), and a release layer (5,300) in an area of said substrate surface, the area comprising at least a region encircling one or more of said devices or one or more portions of said region,
• On said area and in contact with said release layer : a wall structure (13,400),
• a cap (10) on top of said wall structure (13,400),
wherein the thickness and materials of the release layer, the wall structure and the substrate are chosen in such a way that when a force is applied to the wall structure and/or the cap, said force being sufficient for removing the cap from the substrate, breaking will occur in the release layer, along the interface between the release layer and the wall structure, or along the interface between the release layer and the substrate,wherein said substrate (1) is a silicon substrate, and wherein said release layer (5) consists of a stack of SiC layers.

9. Device according to claim 8, wherein said wall structure (13,400) comprises at least two regions of different metals connected by welding.

10. Device according to claim 8 or 9, wherein said release layer (5,300) has a different thermal expansion coefficient than the portion of the wall structure (13,400) which is in direct contact with said release layer.

11. Device according to any one of claims 8 to 10, wherein said device is a MEMS device.

12. A method for removing a temporary cap from a capped device according to any one of claims 8 to 11, said method comprising:
• Heating said release layer (5,300) and at least a portion of said wall structure (13,400) which is in contact with said release layer,
OR
• Heating said release layer (5,300) and at least a portion of said wall structure (13,400) which is in contact with said release layer, whilst simultaneously applying a mechanical force to said wall structure and/or said cap (10,500),
OR
• applying a mechanical force to said wall structure (13,400) and/or said cap (10,500).

## Patentansprüche

1. Ein Verfahren zur Herstellung einer vorläufigen Schutzkappe auf einer Halbleitervorrichtung, insbesondere auf einer MEMS-Vorrichtung, wobei das Verfahren die Schritte umfasst:
- Vorsehen eines Halbleitersubstrats (1,100),
- Herstellen einer oder mehrerer Halbleitervorrichtung(en) auf einer Oberfläche des Substrats (2,200),
- Herstellen einer Trennschicht (5,300) in einem Bereich der Substratoberfläche, der Bereich mindestens eine Region umfassend die eine oder mehrere der Vorrichtung(en) oder einen oder mehrere Teil(e) der Region umkreist,
- Herstellung auf dem Bereich und in Kontakt mit der Trennschicht: einer oder mehrerer Wandstruktur(en) (13,400) um eine oder mehrere der Vorrichtung(en),
- Herstellen einer Schutzkappe (10,500) auf der einen oder mehreren Wandstruktur(en) um die eine oder mehrere Vorrichtung(en) zu schützen,
wobei die Dicke und Materialien der Trennschicht, der einen oder mehreren Wandstruktur(en) sowie des Substrats derart gewählt sind dass wenn eine Kraft an der Wandstruktur und/oder der Schutzkappe angewendet wird, wobei diese Kraft ausreichend ist die Schutzkappe vom Substrat zu entfernen, ein Bruch in der Trennschicht, entlang der Schnittstelle zwischen der Trennschicht und der einen oder mehreren Wandstruktur(en), oder entlang der Schnittstelle zwischen der Trennschicht und dem Substrat auftritt.

2. Verfahren nach Anspruch 1, wobei die Trennschicht (5,300) während des Schritts der Herstellung der einen oder mehreren Halbleitervorrichtung(en) auf der Oberfläche hergestellt wird.

3. Verfahren nach Anspruch 1, wobei die Trennschicht (5,300) zusätzlich zu den Schritt der Herstellung der einen oder mehreren Halbleitervorrichtung(en) auf der Oberfläche hergestellt wird.

4. Verfahren nach einem der Ansprüche 1 bis 3, wobei:
- es sich beim Halbleitersubstrat (1,100) um ein Siliziumsubstrat handelt,
- wobei die Trennschicht (5,300) durch Ablagern einer Sequenz von Siliziumkarbidschichten im Wege der plasmaunterstützten chemischen Gasphasenabscheidung hergestellt wird.

5. Verfahren nach einem der Ansprüche 1 bis 4, wobei die Trennschicht (5,300) einen anderen Wärmeausdehnungskoeffizienten aufweist als der Teil der Wandstruktur (13,400) der sich mit der Trennschicht in direktem Kontakt befindet.

6. Verfahren nach einem der Ansprüche 1 bis 5, wobei die Wandstruktur (13) dadurch hergestellt wird dass:
- eine Metallschicht oder ein Stapel Metallschichten auf die Trennschicht (5) abgelagert wird, um so eine erste, die eine oder mehreren Vorrichtung(en) (2) umgebende Wandunterstruktur (6) zu bilden,
- Vorsehen einer Schutzkappe (10) und Ablagern einer Metallschicht oder eines Stapels Metallschichten auf die Schutzkappe, um so eine zweite Wandunterstruktur (11) zu bilden, die der ersten Wandunterstruktur (6) entspricht,
- Kontaktieren der ersten und zweiten Wandunterstruktur unter Wärmezufuhr um eine Schweißverbindung zwischen der ersten und zweiten Wandunterstruktur zu bilden, um dadurch die Wandstruktur (13) zu bilden.

7. Verfahren nach Anspruch 6, wobei die erste Wandunterstruktur (6) eine Cu-Schicht, und die zweite Wandunterstruktur (11) eine Sn-Schicht umfasst, und wobei die Schweißverbindung eine Cu-Sn-Bindung ist.

8. Eine Verkappte Halbleitervorrichtung, umfassend:
- ein Substrat (1,100) auf seiner Oberfläche umfassend eine oder mehrere Halbleitervorrichtungen (2,200), sowie eine Trennschicht (5,300) in einem Bereich der Substratoberfläche, der Bereich umfassend mindestens eine Region die eine oder mehrere der Vorrichtung(en) oder einen oder mehrere Teil(e) der Region umkreist,
- auf dem Bereich und in Kontakt mit der Trennschicht: eine Wandstruktur (13,400),
- eine Schutzkappe (10) auf der Oberseite der Wandstruktur (13,400),
wobei die Dicke und Materialien der Trennschicht, der Wandstruktur sowie des Substrats derart gewählt sind dass wenn eine Kraft an der Wandstruktur und/oder der Schutzkappe angewendet wird, wobei diese Kraft ausreichend ist die Schutzkappe vom Substrat zu entfernen, ein Bruch in der Trennschicht, entlang der Schnittstelle zwischen der Trennschicht und der Wandstruktur, oder entlang der Schnittstelle zwischen der Trennschicht und dem Substrat auftritt, wobei es sich bei der Trennschicht (5) um einen Stapel SiC-Schichten handelt.

9. Vorrichtung nach Anspruch 8, wobei die Wandstruktur (13,400) mindestens zwei Regionen aus unterschiedlichen Metallen umfasst die miteinander durch Schweißen verbunden sind.

10. Vorrichtung nach Anspruch 8 oder 9, wobei die Trennschicht (5,300) einen anderen Wärmeausdehnungskoeffizienten aufweist als der Teil der Wandstruktur (13,400) der sich unmittelbar mit der Trennschicht in Kontakt befindet.

11. Vorrichtung nach einem der Ansprüche 8 bis 10, wobei die Vorrichtung eine MEMS-Vorrichtung ist.

12. Ein Verfahren zur Entfernung einer vorläufigen Schutzkappe von einer gekappten Vorrichtung nach einem der Ansprüche 8 bis 11, wobei das Verfahren umfasst:
- Wärmen der Trennschicht (5,300) und mindestens eines Teils der Wandstruktur (13,400) die die Trennschicht kontaktiert,
- Wärmen der Trennschicht (5,300) und mindestens eines Teils der Wandstruktur (13,400) die die Trennschicht kontaktiert, unter gleichzeitiger Anwendung einer mechanischen Kraft auf die Wandstruktur und/oder die Schutzkappe (10,500),
ODER
- Anwendung einer mechanischen Kraft auf die Wandstruktur (13,400) und/oder die Schutzkappe (10,500).

## Revendications

1. Procédé pour produire un capuchon temporaire sur un dispositif à semi-conducteur, en particulier un dispositif MEMS, ledit procédé comprenant les étapes de :
• fourniture d'un substrat semi-conducteur (1, 100),
• production sur une surface dudit substrat d'un ou plusieurs dispositifs à semi-conducteur (2, 200),
• production d'une couche antiadhésive (5, 300) dans une zone de ladite surface de substrat, la zone comprenant au moins une région encerclant un ou plusieurs desdits dispositifs ou une ou plusieurs parties de ladite région,
• production sur ladite zone et en contact avec ladite couche antiadhésive de : une ou plusieurs structures de paroi (13, 400) autour desdits un ou plusieurs dispositifs,
• production sur lesdites une ou plusieurs structures de paroi d'un capuchon (10, 500) de manière à protéger lesdits un ou plusieurs dispositifs,
dans lequel l'épaisseur et les matériaux de la couche antiadhésive, les une ou plusieurs structures de paroi et le substrat sont choisis de telle manière que lorsqu'une force est appliquée à la structure de paroi et/ou au capuchon, ladite force étant suffisante pour enlever le capuchon du substrat, une rupture se produit dans la couche antiadhésive, le long de l'interface entre la couche antiadhésive et les une ou plusieurs structures de paroi, ou le long de l'interface entre la couche antiadhésive et le substrat.

2. Procédé selon la revendication 1, dans lequel ladite couche antiadhésive (5, 300) est produite pendant ladite étape de production d'un ou plusieurs dispositifs à semi-conducteur sur ladite surface.

3. Procédé selon la revendication 1, dans lequel ladite couche antiadhésive (5, 300) est produite en plus de ladite étape de production des un ou plusieurs dispositifs à semi-conducteur sur ladite surface.

4. Procédé selon l'une quelconque des revendications 1 à 3, dans lequel :
• ledit substrat semi-conducteur (1, 100) est un substrat en silicium,
• dans lequel ladite couche antiadhésive (5, 300) est obtenue par dépôt d'une séquence de couches de carbure de silicium par dépôt chimique en phase vapeur activé par plasma.

5. Procédé selon l'une quelconque des revendications 1 à 4, dans lequel ladite couche antiadhésive (5, 300) a un coefficient de dilatation thermique différent de la partie de la structure de paroi (13, 400) qui est en contact direct avec ladite couche antiadhésive.

6. Procédé selon l'une quelconque des revendications 1 à 5, dans lequel ladite structure de paroi (13) est produite par :
• dépôt d'une couche de métal ou un empilage de couches de métal sur ladite couche antiadhésive (5), de manière à former une première sous-structure de paroi (6) autour desdits un ou plusieurs dispositifs (2),
• fourniture d'un capuchon (10) et dépôt d'une couche de métal ou un empilage de couches de métal sur ledit capuchon, de manière à former une deuxième sous-structure de paroi (11), correspondant à ladite première sous-structure de paroi (6),
• mise en contact desdites première et deuxième sous-structures de paroi en ajoutant de la chaleur de manière à former un raccord soudé entre lesdites première et deuxième sous-structures de paroi, de manière à former ladite structure de paroi (13).

7. Procédé selon la revendication 6, dans lequel ladite première sous-structure de paroi (6) comprend une couche de Cu, et ladite deuxième sous-structure de paroi (11) comprend une couche de Sn, et dans lequel ledit raccord soudé est un joint Cu-Sn.

8. Dispositif semi-conducteur coiffé, comprenant :
• un substrat (1, 100) comprenant sur sa surface un ou plusieurs dispositifs à semi-conducteur (2, 200), et une couche antiadhésive (5, 300) dans une zone de ladite surface de substrat, la zone comprenant au moins une région encerclant un ou plusieurs desdits dispositifs ou une ou plusieurs parties de ladite région,
• sur ladite zone et en contact avec ladite couche antiadhésive : une structure de paroi (13, 400),
• un capuchon (10) au-dessus de ladite structure de paroi (13, 400), où l'épaisseur et les matériaux de la couche antiadhésive, la structure de paroi et le substrat sont choisis de telle manière qu'une force soit appliquée à la structure de paroi et/ou au capuchon, ladite force étant suffisante pour enlever le capuchon du substrat, une rupture se produit dans la couche antiadhésive, le long de l'interface entre la couche antiadhésive et la structure de paroi, ou le long de l'interface entre la couche antiadhésive et le substrat, où ledit substrat (1) est un substrat en silicium, et où ladite couche antiadhésive (5) est constituée d'un empilage de couches de SiC.

9. Dispositif selon la revendication 8, dans lequel ladite structure de paroi (13, 400) comprend au moins deux régions de métaux différents raccordées par soudage.

10. Dispositif selon la revendication 8 ou 9, dans lequel ladite couche antiadhésive (5, 300) a un coefficient de dilatation thermique différent de la partie de la structure de paroi (13, 400) qui est en contact direct avec ladite couche antiadhésive.

11. Dispositif selon l'une quelconque des revendications 8 à 10, dans lequel ledit dispositif est un dispositif MEMS.

12. Procédé pour enlever un capuchon temporaire d'un dispositif coiffé selon l'une quelconque des revendications 8 à 11, ledit procédé comprenant :
• le chauffage de ladite couche antiadhésive (5, 300) et au moins une partie de ladite structure de paroi (13, 400) qui est en contact avec ladite couche antiadhésive,
OU
• le chauffage de ladite couche antiadhésive (5, 300) et au moins une partie de ladite structure de paroi (13, 400) qui est en contact avec ladite couche antiadhésive, tout en appliquant simultanément une force mécanique à ladite structure de paroi et/ou en appliquant simultanément une force mécanique à ladite structure de paroi et/ou audit capuchon (10, 500),
OU
• l'application d'une force mécanique à ladite structure de paroi (13, 400) et/ou audit capuchon (10, 500).
